# EUROPÄISCHE PATENTSCHRIFT

(11) **EP 2 615 472 B1**
(45) Veröffentlichungstag und Bekanntmachung des Hinweises auf die Patenterteilung: **23.11.2016**
(21) Anmeldenummer: 13000022.7
(22) Anmeldetag: 03.01.2013
(51) Int. Cl.: G01R 31/00, G01R 19/00, G01R 35/00, G01R 1/20

(54) **Einrichtung und Verfahren zur Überwachung eines Stromes eines Leitungsabschnitts**
Device and method for monitoring a current of a conductor section
Dispositif et procédé de surveillance d'un courant d'un segment conducteur

(30) Priorität: 16.01.2012 DE 102012000557
(43) Veröffentlichungstag der Anmeldung: 17.07.2013
(73) Patentinhaber: Micronas GmbH, 79108 Freiburg (DE)
(72) Erfinder: Albrecht, Stefan, Dr., 67294 Mauchenheim (DE)
(74) Vertreter: Koch Müller Patentanwaltsgesellschaft mbH

(56) Entgegenhaltungen:
- EP-A2- 0 878 717
- WO-A1-01/27641
- WO-A1-2006/002446

## Beschreibung

Die Erfindung betrifft eine Überwachungseinrichtung gemäß dem Oberbegriff des Patentanspruchs 1 und ein Verfahren zur Überwachung eines Leitungsabschnitts mit einer Überwachungseinrichtung gemäß dem Oberbegriff des Patentanspruchs 12.

Aus der EP 0 206 488 A1 und US 6 285 191 B1 sind Messeinrichtungen zur Überwachungen von Strömen insbesondere von Batterien in Autos bekannt. Des Weiteren sind der US 6 522 123 B2 und der US 2005 / 0 151 543 A1, der US 4 277 749, der DE 100 13 345 A1 und der US 6 285 191 B1 ebenfalls gattungsgemäße Messeinrichtungen bekannt. Weitere Messeinrichtungen sind aus der EP 0 878 717 A2 und aus der WO 2006 / 002446 A1 bekannt.

Hierbei wird gemäß der Offenbarung der US 6 285 191 B1 der Strom einer Masseleitung überwacht, indem in einer ersten Alternative aus dem gemessenen Spannungsabfall des Massekabels und dem bekannten Widerstand der Masseleitung der Strom auf Grundlage des Ohm'schen Gesetzes ermittelt wird. Gemäß einer zweiten Alternative wird der Strom in dem Massekabel bei einem unbekannten Widerstand des Massekabels mittels eines sich selbst eichenden Instrumentenverstärkers aus dem Spannungsabfall ermittelt. Die Eichung wird unter Verwendung eines Präzisionswiderstandes und einer Präzisionsstromquelle durchgeführt. Des Weiteren wird der Spannungsabfall am Massekabel mittels eines einstellbaren Spannungsteilers an einen Eingang des Instrumentenverstärkers geleitet. Der Spannungsteiler muss ebenfalls kalibriert werden. Aus dem Vergleich des Spannungsabfalls an dem Präzisionswiderstand von dem Ausgang des Instrumentenverstärkers und der Stromquelle wird auf den Strom in dem Massekabel geschlossen.

In der EP 0 206 488 A1 wird offenbart, den Spannungsabfall in einem stromdurchflossenen Leiter, insbesondere in dem Massekabel, mittels einer Kelvin Messanordnung zu messen. Aus dem Spannungsabfall wird die Stromstärke in dem Leiter bestimmt. Zu der Durchführung des Messverfahrens wird in einem ersten Schritt mittels der Kelvin Messanordnung eine Konstantstromquelle an den Leiter angeklemmt, um ein Messgerät mit einem bekannten Strom aus der Stromquelle zu eichen. In dem Betriebsfall, d. h. wenn das Massekabel mit Strom aus der Batterie, bzw. der verallgemeinert ausgedrückt der Leiter stromdurchflossen ist, wird mittels des zuvor geeichten Messgeräts aus dem gemessenen Spannungsabfall an dem Massekabel die Stromstärke in dem Massekabel ermittelt.

Vor diesem Hintergrund besteht die Aufgabe der Erfindung darin, eine Überwachungseinrichtung und ein Verfahren zur Überwachung eines Leitungsabschnitts mit einer Überwachungseinrichtung anzugeben, die jeweils den Stand der Technik weiterbilden.

Die Aufgabe wird durch eine Überwachungseinrichtung mit den Merkmalen des Patentanspruchs 1 und durch ein Verfahren zur Überwachung eines Leitungsabschnitts mit einer Überwachungseinrichtung mit den Merkmalen des Patentanspruchs 12 gelöst. Vorteilhafte Ausgestaltungen der Erfindung sind Gegenstand von Unteransprüchen.

Gemäß dem ersten Gegenstand der Erfindung wird eine Überwachungseinrichtung bereitgestellt, aufweisend einen ersten Leitungsabschnitt mit einer ersten Anschlussstelle und einer von der ersten Anschlussstelle in Leitungsrichtung beabstandeten zweiten Anschlussstelle, und eine Steuerungseinheit und eine erste Stromermittlungseinheit, aufweisend eine erste Stromquelle, wobei die erste Stromquelle mit einer ersten Anschlussleitung mit der ersten Anschlussstelle verschaltet ist und mit einer zweiten Anschlussleitung mit der zweiten Anschlussstelle verschaltet ist und einen ersten Strom ausgibt, einen ersten Schalter mit einem Steuerungseingang, wobei der erste Schalter in die erste Anschlussleitung eingeschleift ist und die erste Stromquelle mit der ersten Anschlussstelle verbindet oder trennt, einen ersten Differenzverstärker mit einen ersten Eingang, einem zweiten Eingang und einem Ausgang, wobei der erste Eingang mit einer dritten Anschlussleitung mit der ersten Anschlussstelle verschaltet ist und der zweiter Eingang mit einer vierten Anschlussleitung mit der zweiten Anschlussstelle verschaltet ist, wobei die Steuerungseinheit zwischen dem Ausgang des ersten Differenzverstärkers und
dem Steuerungseingang des Schalters eingeschleift ist, wobei der erste Leitungsabschnitt mit einem Iststrom beaufschlagt ist und in einem ersten Zustand der erste Schalter geschlossen ist und der erste Strom in dem ersten Leitungsabschnitt zusätzlich zu dem Ist-strom eingeprägt ist und zwischen dem ersten Eingang und dem zweiten Eingang des ersten Differenzverstärkers eine Spannung bedingt durch die Größe des Iststroms und die Größe des ersten Stroms anliegt, und in einem zweiten Zustand der erste Schalter geöffnet ist und zwischen dem ersten Eingang und dem zweiten Eingang des ersten Differenzverstärkers eine zweite ausschließlich durch den Iststrom bedingte Spannung anliegt, und in einem zweiten Zustand der erste Schalter geöffnet ist und zwischen dem ersten Eingang und dem zweiten Eingang des ersten Differenzverstärkers eine zweite ausschließlich durch den Iststrom bedingte Spannung anliegt, und ein zweiter Leitungsabschnitt mit einer zweiten Stromermittlungseinheit mit einem zweiten Differenzverstärker vorgesehen ist und ein zweiter Strom mittels einer zweiten Stromquelle in den zweiten Leitungsabschnitt eingespeist ist, und der erste Strom und der zweite Strom im Wesentlichen entgegengesetzt gleich groß sind, und die Steuerungseinheit einen dritten Differenzverstärker aufweist und ein erster Eingang des dritten Differenzverstärkers mit dem Ausgang des ersten Differenzverstärkers und ein zweiter Eingang des dritten Differenzverstärkers mit dem Ausgang des zweiten Differenzverstärkers verschaltet ist und der erste Differenzverstärker mit dem zweiten Differenzverstärker und dem dritten Differenzverstärker eine mehrstufigen Verstärkereinheit ausbilden, und am Ausgang der mehrstufigen Verstärkereinheit eine Summe der an dem ersten Leitungsabschnitt und dem zweiten Leitungsabschnitt gemessenen Spannungsdifferenzen anliegt, und die Steuerungseinheit eingerichtet ist, aus den beiden Spannungen aus dem ersten Zustand und dem zweiten Zustand die Größe des Iststroms zu bestimmen.

Gemäß dem zweiten Gegenstand der Erfindung wird ein Verfahren zur Überwachung eines ersten Leitungsabschnitts mit einer Überwachungseinrichtung, bereitgestellt, wobei der erste Leitungsabschnitt eine erste Anschlussstelle und eine, von der ersten Anschlussstelle in Leitungsrichtung beabstandete, zweite Anschlussstelle aufweist, wobei die Überwachungseinrichtung eine Steuerungseinheit und eine erste Stromermittlungseinheit aufweist, und die erste Stromermittlungseinheit eine Stromquelle aufweist, wobei die erste Stromquelle mit einer ersten Anschlussleitung mit der ersten Anschlussstelle und mit einer zweiten Anschlussleitung mit der zweiten Anschlussstelle verschaltet ist und einen ersten Strom ausgibt, wobei ein erster Schalter mit einem Steuerungseingang vorgesehen ist und der erste Schalter in die erste Anschlussleitung eingeschleift ist und der erste Schalter die erste Stromquelle mit der ersten Anschlussstelle verbindet oder trennt, wobei ein erster Differenzverstärker, mit einen ersten Eingang, einem zweiten Eingang und einem Ausgang vorgesehen ist und der erste Eingang des ersten Differenzverstärkers mittels einer dritten Anschlussleitung mit der ersten Anschlussstelle verschaltet ist und der zweite Eingang des ersten Differenzverstärkers mit einer vierten Anschlussleitung mit der zweiten Anschlussstelle verschaltet ist, und wobei die Steuerungseinheit zwischen dem Ausgang des ersten Differenzverstärkers und dem Steuerungseingang des ersten Schalters eingeschleift ist, wobei der erste Leitungsabschnitt mit einem Iststrom beaufschlagt wird, und wobei in einem ersten Zustand der erste Schalter geschlossen ist und der
erste Strom in dem ersten Leitungsabschnitt zusätzlich zu dem Iststrom eingeprägt wird und zwischen dem ersten Eingang und dem zweiten Eingang des ersten Differenzverstärkers eine Spannung bedingt durch die Größe des Iststroms und die Größe des ersten Stroms anliegt, und in einem zweiten Zustand der erste Schalter geöffnet wird und zwischen dem ersten Eingang und dem zweiten Eingang des ersten Differenzverstärkers eine zweite ausschließlich durch den Iststrom bedingte Spannung anliegt, und in einem zweiten Zustand der erste Schalter geöffnet ist und zwischen dem ersten Eingang und dem zweiten Eingang des ersten Differenzverstärkers eine zweite ausschließlich durch den Iststrom bedingte Spannung anliegt, und ein zweiter Leitungsabschnitt mit einer zweiten Stromermittlungseinheit mit einem zweiten Differenzverstärker vorgesehen ist und ein zweiter Strom mittels einer zweiten Stromquelle in den zweiten Leitungsabschnitt eingespeist wird, und der erste Strom und der zweite Strom im Wesentlichen entgegengesetzt gleich groß sind, und die Steuerungseinheit einen dritten Differenzverstärker aufweist und ein erster Eingang des dritten Differenzverstärkers mit dem Ausgang des ersten Differenzverstärkers und ein zweiter Eingang des dritten Differenzverstärkers mit dem Ausgang des zweiten Differenzverstärkers verschaltet wird und der erste Differenzverstärker mit dem zweiten Differenzverstärker und dem dritten Differenzverstärker eine mehrstufigen Verstärkereinheit ausbilden, und am Ausgang der mehrstufigen Verstärkereinheit eine Summe der an dem ersten Leitungsabschnitt und dem zweiten Leitungsabschnitt gemessenen Spannungsdifferenzen anliegt, und aus dem ersten Zustand und dem zweiten Zustand mittels der Steuerungseinheit aus den beiden Spannungen die Größe des Iststroms bestimmt wird.

Ein Vorteil der Überwachungseinrichtung bzw. des Verfahrens zur Überwachung eines ersten Leitungsabschnitts mit einer Überwachungseinrichtung ist es, dass während des normalen Betriebs eines Geräts der Strom in einer Leitung des Gerätes, insbesondere einer Masseleitung einer elektrischen Verbrauchers, ohne ein Auftrennen der zu überwachenden Leitung und insbesondere ohne ein Dazwischenschalten eines kostenintensiven sogenannten Shunt Widerstandes und auch ohne Kenntnis des Leitungswiderstandes des zu überwachenden Leitungsabschnitts ermitteln lässt. Des Weiteren erübrigt sich auch eine Kalibrierung d. h. Eichung des Spannungsmessers vor einer Messung. Auch wird für die Ermittlung der Spannung an einem Leitungsstück kein Spannungsteiler zwischen dem Spannungsmesser und der Anschlußstelle benötigt. Untersuchungen haben gezeigt, dass das Einprägen des ersten Stroms in einem laufenden Betrieb in der überwiegenden Anzahl der Anwendungen den laufenden Betriebs des Geräts nur wenig oder gar nicht beeinträchtigt. Vorteilhaft ist, wenn die Stromstärke des ersten Stroms im Allgemeinen kleiner als der Iststrom gewählt wird. Indem auch sehr kleine Spannungswerte unterhalb 100 mV sich präzise messen lassen, eignet sich das Verfahren auch bei einem kleinen Leitungswiderstand eines Leitungsabschnitts von unterhalb 0,1 Ohm. Des Weiteren lässt sich das Verfahren durch die präzise Messung kleiner Spannungen besonders für eine Überwachung von Leitungen bei Strömen mit einer hohen Stromstärke, vorzugsweise oberhalb 100mA, höchst vorzugsweise oberhalb 1 A, verwenden.

Es versteht sich, dass entsprechend dem Ohmschen Gesetz sich der Widerstand des Leitungsabschnitts aus einer einzigen Messung mit einer bekannten Stromstärke und der gemessenen Spannung bestimmen lässt, sofern kein Iststrom eingeprägt ist. Untersuchungen haben jedoch gezeigt, dass die Genauigkeit der Bestimmung des Widerstandes insbesondere bei Massekabeln unter anderem wegen des sehr geringen Leitungswiderstandes völlig unzureichend ist. Des Weiteren hängt der Widerstand der Leitungsabschnitte von dem Alter der Leitung und den Umgebungseinflüssen wie Feuchtigkeit und Temperatur ab und ist teilweise in bestimmten Bereichen der Stromstärke nichtlinear. Hierdurch erzielen Widerstandsmessungen an nicht stromdurchflossenen Leitern insbesondere wenn die Messungen vor längerer Zeit ausgeführt worden sind nur ungenaue Ergebnisse. Im Unterschied hierzu erzielt die erfindungsgemäße Überwachungseinrichtung eine wesentlich genauere Ermittlung der Stromstärke unter realen Betriebsbedingungen. Es sei angemerkt, dass die Steuereinheit eingerichtet ist, die Größe des Iststroms mittels des Wertes der Spannung in dem ersten Zustand und mittels des Wertes der Spannung in den zweiten Zustand und der Größe des ersten Stroms zu bestimmen. Anders ausgedrückt wird die Berechnung der Größe des Iststroms mittels der Steuereinheit aus einer Messung der Spannung in dem ersten Zustand und aus einer Messung der Spannung in den zweiten Zustand und einer Messung der Höhe des ersten Stroms durchgeführt. Hierdurch lässt sich die bisher im Stand der Technik angewendete und zumeist sehr ungenaue Bestimmung des im Allgemeinen sehr kleinen Leitungswiderstands des ersten Leitungsabschnitts vermeiden. Gemäß einer Weiterbildung wird zur Bestimmung des Iststroms die Beziehung Iststrom ist gleich dem Produkt aus dem ersten Strom mal der in dem zweiten Zustand gemessenen Spannung dividiert durch die Differenz aus der in ersten Zustand gemessenen Spannung und der in dem zweiten Zustand gemessenen Spannung benutzt. Hierdurch lässt sich die Größe des Iststroms ohne Berechnung des Leitungswiderstandes des ersten Leitungsabschnitts durchführen.

Gemäß einer Weiterbildung wird der erste Strom in einer ersten Alternative als ein Gleichstrom oder in einer zweiten Alternative als ein Wechselstrom eingeprägt. Untersuchungen haben gezeigt, dass wenn gemäß der ersten Alternative der erste Strom als Gleichstrom eingeprägt wird, in dem Leiter und in dem Gerät sich keine zeitlich verändernden Störungen in das Stromnetz eingeprägt werden. Es ist hierbei vorteilhaft, den Gleichstrom beim Anschalten der Stromquelle an den Leiter den ersten Strom langsam auf eine erste Nennstärke hoch zu fahren und vor einem Trennen der Stromquelle von dem Leitungsabschnitt den ersten Strom langsam auf Null herunterzufahren. Eine Ausführung der gemäß der zweiten Alternative ist besonders vorteilhaft, wenn der Iststrom selbst ein Wechselstrom darstellt und die Einprägung des ersten Gleichstroms nicht wünschenswert ist. In einer Ausführungsform ist es bevorzugt, dass die Frequenz des ersten Stroms unterschiedlich zu der Frequenz des Iststroms ausgebildet ist. Gemäß einer Ausführungsform wird mittels der Steuerungseinheit ein Wechselstrom in den ersten Leitungsabschnitt derart eingespeist, dass die Variation der Spannung mittels eines Lock-In Prinzips ermittelt wird und hierdurch auch bei kleinen Änderungen der Spannungen, vorzugsweise unterhalb von 0,1 V, höchst vorzugsweise unterhalb von 1 mV, die Größe des Iststroms zuverlässig bestimmen lässt.

In einer bevorzugten Weiterbildung weist die erste Stromquelle einen mit der Steuerungseinheit verschalteten Steuerungseingang auf. Hierdurch lässt sich mittels der Steuerungseinheit die erste Stromquelle sowohl an als auch abschalten. Des Weiteren lässt sich die die Höhe des ersten Stroms und gegebenenfalls die Frequenz des ersten Stroms in der Ausführungsform des Wechselstroms einstellen und insbesondere auch regeln. Als Führungsgröße bei der Regelung der ersten Stromquelle lässt sich unter anderem die Höhe der Spannungsdifferenz zwischen der Messung während dem ersten und dem zweiten Zustand verwenden.

Gemäß einer anderen Weiterbildung umfasst die erste Stromermittlungseinheit einen ADC, wobei der ADC zwischen dem Ausgang des ersten Differenzverstärkers und der Steuerungseinheit geschaltet ist. Ein Vorteil ist, dass sich durch die Wandlung der analogen Spannungsgröße in einen digitalen Zahlenwert die Daten in der Steuerungseinheit, welche vorzugsweise einen Prozessor umfasst, einfach und zuverlässig verarbeiten lassen.

In einer bevorzugten Ausführungsform ist die erste Stromquelle mittels des ersten Schalters und eines zweiten Schalters und eines dritten Schalters und eines vierten Schalters in Form einer H-Brückenschaltung mit dem ersten Leitungsabschnitt verschaltet. Ein Vorteil der H-Brückenschaltung ist es, dass sich der erste Strom der ersten Stromquelle ohne weiteres in beiden technischen Stromrichtungen in den ersten Leitungsabschnitt einspeisen lässt.

In einer Weiterbildung ist der erste Differenzverstärker mittels einer H-Brückenschaltung mit dem ersten Leitungsabschnitt verschaltet. Hierdurch lassen sich die beiden Eingänge des Differenzverstärkers derart mit dem ersten Leitungsabschnitt verbinden, dass die Spannungsdifferenz zwischen den beiden Eingängen immer in der gleichen Richtung anliegt bzw. das gleiche Vorzeichen aufweist. Ferner ist es vorteilhaft, eine Schaltungseinheit bestehend aus dem ersten Differenzverstärker und dem ADC mittels einer H-Brückenschaltung mit dem ersten Leitungsabschnitt zu verschalten.

Ein zweiter Leitungsabschnitt ist mit einer zweiten Stromermittlungseinheit mit einem zweiten Differenzverstärker vorgesehen, wobei ein zweiter Strom in den zweiten Leitungsabschnitt eingespeist wird. Vorzugsweise grenzt der zweite Leitungsabschnitt unmittelbar an den ersten Leitungsabschnitt. Es versteht sich, dass die zweite Stromermittlungseinheit die zu ersten Stromermittlungseinheit korrespondierenden Schaltungskomponenten aufweist und die Schaltungskomponenten ebenfalls korrespondierend verschaltet sind. Es verseht sich, dass der erste Strom und der zweite Strom im Wesentlichen entgegengesetzt gleich groß sind. Ein Vorteil ist, dass außerhalb der beiden Leitungsabschnitte kein Strom eingespeist bzw. eingeprägt wird. Hierdurch wird eine Störung oder Beeinflussung des Geräts im Wesentlichen vermeiden.

Die Steuerungseinheit weist einen dritten Differenzverstärker auf, wobei ein erster Eingang des dritten Differenzverstärkers mit dem Ausgang des ersten Differenzverstärkers und ein zweiter Eingang des dritten Differenzverstärkers mit dem Ausgang des zweiten Differenzverstärkers verschaltet ist und der erste Differenzverstärker mit dem zweiten Differenzverstärker und dem dritten Differenzverstärker eine mehrstufige Verstärkereinheit ausbilden, wobei am Ausgang der mehrstufigen Verstärkereinheit eine Summe der an dem ersten Leitungsabschnitt und dem zweiten Leitungsabschnitt gemessenen Spannungsdifferenzen anliegt.

In einer anderen Ausführungsform ist neben dem ersten Leitungsabschnitt und dem zweiten Leitungsabschnitt ein dritter Leitungsabschnitt vorgesehen. Der erste Leitungsabschnitt und der zweite Leitungsabschnitt sind vorzugsweise zwischen einer Spannungsquelle oder einer Stromquelle, beispielsweise einer Batterie und einem Massepotential in Serie geschaltet. Dem ersten Leitungsabschnitt ist wenigstens eine erste Stromquelle mit einem ersten Differenzverstärker und dem zweiten Leitungsabschnitt wenigstens eine zweite Stromquelle mit einem zweiten Differenzverstärker zugeordnet. Der dritte Leitungsabschnitt umfasst vorliegend eine Batterie mit dem zugehörigen Innenwiderstand der Batterie und einen Leitungsschalter. Der Leitungsschalter ist zwischen einem vorgegeben Punkt der mit einem Verbraucher verschaltet ist, und beispielsweise in einem Kraftfahrzeug mit der Nummer 15 bezeichnet wird, und dem Pluspol der Batterie eingeschleift. Der Leitungsschalter verbindet oder trennt den Pluspol der Batterie mit demjenigen Abschnitt der Leitung der zu dem Verbraucher führt. Parallel zu der zweiten Stromquelle ist eine dritte einstellbare Stromquelle vorgesehen. Der Steuerungseingang der dritten Stromquelle ist mit der Steuerungseinheit verschaltet. Mittels der dritten Stromquelle lässt sich auf einfache Weise die Höhe des dritten Stroms derart erhöhen oder erniedrigen, so dass der Summenwert des zweiten Stroms und des dritten Stroms gleich oder vorzugsweise näherungsweise gleich dem Wert des ersten Stroms ist.

In einer Weiterbildung ist eine erste Schaltungsvorrichtung vorgesehen. Die erste Schaltungsvorrichtung umfasst einen Analog Digital Wandler und einen Differenzverstärker und weist einen mittels einer dritten H-Brücke mit einem ersten Leitungsabschnitt verschaltenden Differenzeingang und einen mit der Steuerungseinheit verschaltenden Ausgang auf. Die dritte H-Brücke umfasst einen neunten Brückenschalter und einen zehnten Brückenschalter.

Zusätzlich zu der ersten Schaltungsvorrichtung ist eine zweite Schaltungsvorrichtung vorgesehen. Die zweite Schaltungsvorrichtung umfasst einen Analog Digital Wandler und einen Differenzverstärker und weist einen mittels einer vierten H-Brücke mit einem zweiten Leitungsabschnitt verschaltenden Differenzeingang und einen mit der Steuerungseinheit verschaltenden Ausgang auf. Die vierte H-Brücke umfasst einen dreizehnten Brückenschalter, einen vierzehnten Brückenschalter, einen fünfzehnten Brückenschalter und einen sechzehnten Brückenschalter. In einem ersten Modus sind alle Brückenschalter der dritten H-Brücke und bei der vierten H-Brücke geöffnet. Ferner sind in dem ersten Modus alle Brückenschalter der ersten H-Brücke und alle Brückenschalter der zweiten H-Brücke geöffnet. Alle Steuerungseingänge sind vorzugsweise mit der Steuerungseinheit ST verschaltet. Ferner ist eine dritte Schaltungsvorrichtung vorgesehen, wobei die dritte Schaltungsvorrichtung einen Differenzverstärker und einen Analog Digital Wandler umfasst.

Indem sowohl die erste bis dritte Stromquelle als auch die erste bis dritte Schaltungsvorrichtung jeweils mittels einer H-Brücke mit den zugeordneten Leitungsabschnitten verschaltet sind, ergibt sich eine große Flexibilität hinsichtlich der Messung der Spannungswerte an dem ersten Leitungsabschnitt und an dem zweiten Leitungsabschnitt und In der Kombination der einzelnen gemessenen Spannungswerte.

Des Weiteren sind ein erster Eingang der dritten Schaltungsvorrichtung mit dem Massepotential und ein zweiter Eingang der dritten Schaltungsvorrichtung mit dem Pluspol der Batterie verbunden. Der erste Eingang und der zweite Eingang bilden einen Differenzeingang aus. Der Ausgang der dritten Schaltungsvorrichtung ist mit der Steuerungseinheit verschaltet.

Wird, der Leitungsschalter geschlossen, fließt der Iststrom aus der Batterie und erzeugt eine Spannungsänderung an dem Differenzeingang der dritten Schaltungsvorrichtung. Die Spannungsänderung ergibt sich grundsätzlich aus einem Vergleich der an den Differenzeingang der dritten Schaltungsvorrichtung anliegenden Spannung bei einem geöffneten Leitungsschalter und bei einem geschlossenen Leitungsschalter. Hierdurch lässt sich die Belastung der Batterien, d. h. die Größe der Stromentnahme ermitteln. Außerdem lässt sich bei einem geöffneten Leitungsschalter aus der gemessenen Spannung der Batterie deren Ladezustand überwachen.

Untersuchungen haben gezeigt, dass sich bei einem geschlossenen Leitungsschalter bei einer Auswertung der Spannungswerte von der ersten Schaltungsvorrichtung und der Spannungswerte bis einschließlich der dritten Schaltungsvorrichtung sich insbesondere auf einen Nebenschluss der Batterie schließen lässt.

In einer weiteren Ausführungsform lässt sich die erste H-Brücke mit der verbundenen ersten Stromquelle als ein erster Schaltungsblock zusammenfassen. Des Weiteren lässt sich die zweite H-Brücke mit der verbundenen zweiten Stromquelle als zweiter Schaltungsblock zusammenfassen. Die dritte H-Brücke lässt sich mit der verbundenen ersten Schaltungsvorrichtung als erster Schaltungsabschnitt und die vierte H-Brücke lässt sich mit der verbundenen zweiten Schaltungsvorrichtung als zweiter Schaltungsabschnitt zusammenfassen. Der erste Schaltungsblock, der zweite Schaltungsblock, der erste Schaltungsabschnitt und der zweite Schaltungsabschnitt lassen sich zu einer ersten Schaltungseinheit zusammenfassen. Mit einer derartigen Schaltungseinheit lässt sich vorzugsweise der Strom bei einem einphasigen Generator oder eines Elektromotor überwachen.

In einer anderen Weiterbildung sind zusätzlich zu der ersten Schaltungseinheit, eine zweite Schaltungseinheit und einer dritte Schaltungseinheit vorgesehen. Die zweite Schaltungseinheit und die dritte Schaltungseinheit weisen einen entsprechenden Aufbau mit der ersten Schaltungseinheit auf. Vorzugsweise ist die erste Schaltungseinheit ist mit einem ersten Generatorzweig und die zweite Schaltungseinheit mit einem zweiten Generatorzweig und die dritte Schaltungseinheit mit einem dritten Generatorzweig jeweils in Serie verschaltet. Hierdurch lässt sich die Stromstärken in jedem der drei Generatorzweige getrennt ermitteln und überwachen.

Untersuchungen haben gezeigt, dass sich die Überwachungseinrichtung für eine Kontrolle bzw. Ermittlung von Strangströmen eines Generators oder eines Elektromotors besonders eignet. Unter Strangströme werden die Ströme in den Ableitungen eines Generators verstanden. Derartige Ströme erreichen ohne weiteres eine Stromstärke von 10 A und mehr.

Ferner eignet sich die Überwachungseinrichtung insbesondere für eine Bestimmung des Ladezustands einer Batterie. Hierbei bilden die erste Anschlussstelle der Pluspol und die zweite Anschlussstelle der Minuspol der Batterie.

Des Weiteren ist die Überwachungseinrichtung zur Kontrolle des Stromes in Massezuleitungen in einem Kraftfahrzeug besonders geeignet. Gerade in der Masseleitung von der Batterie zu dem Kraftfahrzeug fließen während des Anlassvorgangs besonders hohe Ströme, wobei es vorteilhaft ist deren Stromstärken zur Fehlererkennung in einem Kraftfahrzeug zu überwachen. Ferner ist es vorteilhaft die Stromstärken in einem Elektrofahrzeug insbesondere während des Anfahrvorgangs zu bestimmen und hierdurch zu überwachen. Weiterhin ist es vorteilhaft, mittels der Überwachungseinrichtung den Ladezustand der Batterie zu bestimmen bzw. zu kontrollieren. Des Weiteren lässt sich mittels der Überwachungseinrichtung die Stromstärke in einem Pluszweig zwischen der Batterie, insbesondere innerhalb des Bordnetzes eines Autos und einem Verbraucher bestimmen bzw. kontrollieren.

Eine weitere besonders vorteilhafte Verwendung besteht in dem Einsatz der Überwachungseinrichtung für eine In-situ-Kalibration von unbekannten Stromstärken in einem Leitungssegment, wobei die Variation der Stromstärke in dem Leitungssegment vorteilhaft wenigstens eine Zehnerpotenz umfasst. Hierdurch lassen sich Leitungssegmente auf einfache und zuverlässige Weise überwachen, die völlig unterschiedliche Stromstärken aufweisen.

Die Erfindung wird nachfolgend unter Bezugnahme auf die Zeichnungen näher erläutert. Hierbei werden gleichartige Teile mit identischen Bezeichnungen beschriftet. Die dargestellte Ausführungsformen sind stark schematisiert, d.h. die Abstände und laterale und vertikale Erstreckung sind nicht maßstäblich und weisen, sofern nicht anders angegeben auch keine ableitbare geometrische Relation zueinander auf. Darin zeigen die:
- Figur 1: eine erste Ausführungsform der Überwachungseinrichtung mit einer ersten Stromermittlungseinheit,
- Figur 2: eine zweite Ausführungsform der Überwachungseinrichtung, wobei von der ersten Überwachungseinrichtung ein erster Strom als Wechselstrom eingeprägt wird,
- Figur 3: ein Ersatzschaltbild von einer Überwachungseinrichtung gemäß der Ausführungsform der Figur 1,
- Figur 4a: ein Ersatzschaltbild von der Überwachungseinrichtung mit einer ersten Stromquelle eingebettet in einer ersten H-Brückenschaltung in einem ersten Schaltungszustand und einer zweiten Stromquelle einbettet in einer zweiten H-Brückenschaltung in einem ersten Schaltungszustand,
- Figur 4b: ein Ersatzschaltbild von der Überwachungseinrichtung der Figur 4a jedoch sind die beiden H-Brückenschaltungen in einem zweiten Schaltungszustand,
- Figur 5: ein Ersatzschaltbild von der Überwachungseinheit mit einer mehrstufigen Verstärkereinheit,
- Figur 6: ein Ersatzschaltbild von einer Überwachungseinrichtung mit einer Parallelschaltung einer zweiten Stromquelle mit einer dritten regelbaren Stromquelle,
- Figur 7: eine vereinfachtes Ersatzschaltbild. der Ausführungsform der Figur 6,
- Figur 8: eine weiteres vereinfachtes Ersatzschaltbild mit einer Vielzahl von Überwachungseinrichtungen.

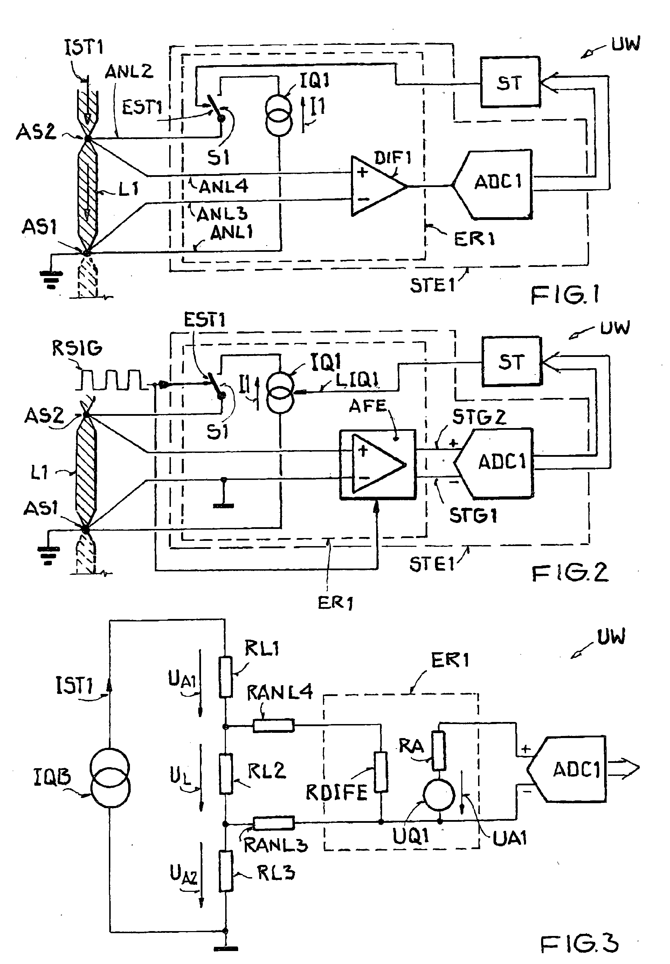

Die Abbildung der Figur 1 zeigt eine Überwachungseinrichtung UW mit einem ersten Leitungsabschnitt L1 mit einer ersten Anschlussstelle AS1 und einer von der ersten Anschlussstelle AS1 in Leitungsrichtung beabstandeten zweiten Anschlussstelle AS2. Die Überwachungseinrichtung UW weist eine Steuerungseinheit ST und eine erste Stromermittlungseinheit STE1 sowie einen ersten Analog Digital Wandler ADC1, einen ersten Differenzverstärker DIF1 und eine erste Stromquelle IQ1 auf. Die erste Stromquelle IQ1 ist mir einer ersten Anschlussleitung ANL1 mit der ersten Anschlussstelle AS1 verschaltet und mit einer zweiten Anschlussleitung ANL2 mit der zweiten Anschlussstelle AS2 verschaltet. Die erste Stromquelle IQ1 gibt einen ersten Strom 11 aus. Des Weiteren ist ein erster Schalter S1 mit einem Steuerungseingang EST1 vorgesehen, wobei der erste Schalter S1 in die erste Anschlussleitung ANL1 eingeschleift ist und die erste Stromquelle IQ1 mit der ersten Anschlussstelle AS1 verbindet oder trennt.

Die erste Schaltungseinheit SE1 weist einem ersten Analog Digital Wandler ADC und einen ersten Differenzverstärker DIF1 auf. Der erste Differenzverstärker DIF1 weist einen ersten Eingang, einen zweiten Eingang und einen Ausgang, wobei der erste Eingang als invertierender Eingang ausgebildet ist und mit einer dritten Anschlussleitung ANL3 mit der ersten Anschlussstelle AS1 verschaltet ist und der zweiter Eingang als nichtinvertierender Eingang ausgebildet ist und mit einer vierten Anschlussleitung ANL4 mit der zweiten Anschlussstelle AS2 verschaltet ist. Der Ausgang des Differenzverstärkers ist mit einem Eingang eines Analog Digital Wandlers ADC verbunden. Der Analog Digital Wandler ADC weist einen mit der Steuerungseinheit ST verbundenen Ausgang auf. Somit ist die erste Schaltungseinheit SE1 zwischen dem Ausgang des ersten Differenzverstärkers DIF1 und dem Steuerungseingang EST1 des Schalters S1 eingeschleift. Des Weiteren ist die Steuerungseinheit ST mit dem Steuerungseingang EST1 des ersten Schalters S1 verschaltet. Der erste Differenzverstärker DIF1 bildet zusammen mit der ersten Stromquelle IQ1 und dem ersten Schalter S1 einen ersten analogen Schaltungsblock ER1 aus.

Der erste Leitungsabschnitt L1 an der ersten Anschlussstelle AS1 mit einem als Massepotential ausgebildeten Referenzpotential verbunden. In dem ersten Leitungsabschnitt L1 fließt ein erster Iststrom IST1, d.h. ein nicht dargestelltes Gerät wird betrieben und nimmt Strom auf. In einem ersten Zustand ist der erste Schalter S1 geschlossen und der erste Strom I1 wird in dem ersten Leitungsabschnitt L1 zusätzlich zu dem ersten Iststrom IST1 eingeprägt. Hierdurch liegt zwischen dem ersten Eingang und dem zweiten Eingang des ersten Differenzverstärkers DIF1 eine erste Spannung U1 an. Die erste Spannung U1 ist bedingt durch die Größe des ersten Iststroms IST1 und die Größe des ersten Stroms I1 und dem nicht vernachlässigbaren Leitungswiderstand des ersten Leitungsabschnitts L1. In einem zweiten Zustand ist der erste Schalter S1 geöffnet und zwischen dem ersten Eingang und dem zweiten Eingang des ersten Differenzverstärkers DIF1 liegt eine zweite ausschließlich durch den ersten Iststrom IST1 bedingte Spannung U2 an. Es versteht sich, dass die zweite Spannung U2 unterschiedlich zu der ersten Spannung U1 ist. Weist der erste Strom I1 die identische technische Stromrichtung wie der erste Iststrom IST1 auf, ist die erste Spannung U1 größer als die zweite Spannung U2. Umgekehrt ist die zweite Spannung U2 größer als die erste Spannung U1, wenn die technische Stromrichtung der beiden Ströme unterschiedlich ist. Es versteht sich, dass hierbei immer der Betrag der ersten Spannung U1 bzw. der zweiten Spannung U2 verstanden wird. Des Weiteren wird angemerkt, dass die Größe des ersten Stroms I1 im Allgemeinen kleiner gewählt wird, als die Größe der ersten Iststroms IST1.

Die Ermittlung der Größe des ersten Iststroms IST1 wird aus der Differenz der ersten Spannung U1 und der zweiten Spannung U2 mittels der Steuerungseinheit ST durchgeführt. Es versteht sich, dass für eine Ermittlung des ersten Iststroms IST1 die Kenntnis der Größe des ersten Stroms I1 notwendig ist. Eine Berechnung oder Kenntnis des Widerstandes des ersten Leitungsabschnitts wird hierdurch in vorteilhafter Weise vermieden.

In der Abbildung der Figur 2 ist eine zweite Ausführungsform der Überwachungseinrichtung UW dargestellt. Im Folgenden werden nur die Unterschiede zu der Abbildung der Figur 1 erläutert. Der erste Differenzverstärker DIV1 ist in eine erste analoge Schaltungseinheit AFE integriert. Die erste analoge Schaltungseinheit AFE1 ist mit einer ersten invertierenden Signalleitung SIG1 und mit einer nichtinvertierenden Signalleitung SIG2 mit dem ersten Analog Digital Wandler ADC1 verbunden. Hierdurch lassen sich an den ersten Analog Digital Wandler ADC1 Differenzsignale anlegen. Des Weiteren liegt an dem Steuerungseingang STE1 des ersten Schalters S1 und an der ersten analogen Schaltungseinheit AFE1 ein rechteckförmiges Signal RSIG an. Die erste Stromquelle IQ1 weist nunmehr einen Steuerungseingang auf. Der Steuerungseingang der ersten Stromquelle IQ1 ist mit der Steuerungseinheit ST mittels einer Steuerleitung LIQ1 verschaltet. Das Signal RSIG wird von einer nicht dargestellten externen Quelle ausgebildet. Gemäß einer nicht dargestellten Alternative lässt sich das Signal RSIG auch mittels der Steuerungseinheit ST erzeugen. Die erste analoge Schaltungseinheit AFE1 bildet zusammen mit der ersten Stromquelle IQ1 und dem ersten Schalter S1 den ersten analogen Schaltungsblock ER1 aus.

Mittels des Signal RSIG wird der erste Schalter S1 abwechselnd geschlossen und geöffnet. Immer wenn der Schalter S1 geschlossen ist wird ein erster Strom I1 eingeprägt. Der erste Strom I1 lässt sich mittels der Steuerungseinheit ST in der Höhe verändern.

Die Figur 3 zeigt ein Ersatzschaltbild von einer Überwachungseinrichtung gemäß der Ausführungsform dargestellt in der Figur 1 bzw. der Ausführungsform dargestellt in der Figur 2. Im Folgenden werden nur die Unterschiede einen der vorstehenden Abbildungen erläutert. Der erste Iststrom IST1 wird von einer Stromquelle IQB in eine Reihenschaltung aus einem ersten Leitungswiderstand RL1 und einem zweiten Leitungswiderstand RL2 und einem dritten Leitungswiderstand RL3 eingeprägt. An dem ersten Leitungswiderstand RL1 fällt eine erste Spannung UA1, an dem zweiten Leitungswiderstand RL2 eine zweite Spannung UL und an dem dritten Widerstand RL3 eine dritte Spannung UA2 ab. Die dritte Anschlussleitung ANL3 ist mittels eines vierten Widerstands RANL3 und die vierte Anschlussleitung ANL4 ist durch einen fünften Widerstand RANL4 abgebildet. Der Eingangswiderstand des ersten Schaltungsblocks ER1 wird mittels eines sechsten Widerstands RDIFE dargestellt. Es sei angemerkt, dass der Eingangwiderstand vorliegend im Wesentlichen durch den Eingangswiderstand des ersten Differenzverstärkers DIF1 bestimmt wird. Der Ausgang des ersten anlogen Schaltungsblocks ER1 wird durch eine erste Spannungsquelle UQ1 mit einem in Reihe liegenden Ausgangswiderstand RA gebildet. Die erste Spannungsquelle UQ1 erzeugt eine erste Ausgangsspannung UA1 welche über dem Ausgangswiderstand RA an den Differenzeingang des ersten Analog Digital Wandlers ADC1 anliegt. Es zeigt sich hierdurch, dass sich eine Überwachungseinrichtung bereits ohne einen Analog Digital Wandler rein in analoger Schaltungstechnik ausbilden lässt.

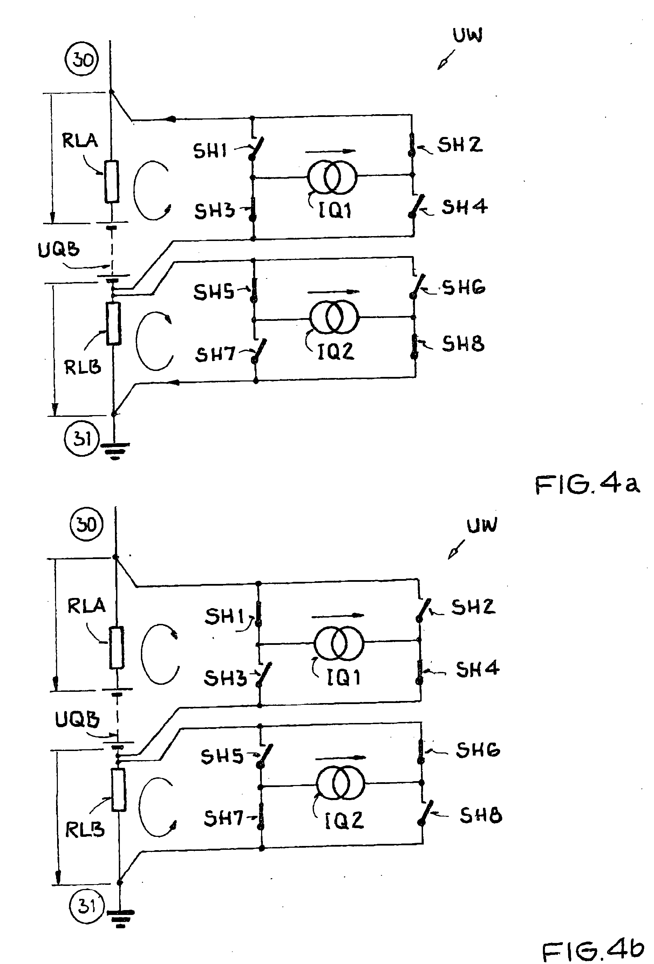

Die Figur 4a zeigt aus Gründen der Übersichtlichkeit ein Teil einer weiteren Ausführungsform der Überwachungseinrichtung UW als stark vereinfachtes Ersatzschaltbild. Im Folgenden werden nur die Unterschiede zu den vorstehenden Abbildungen erläutert. Die erste Stromquelle IQ1 ist mit einer ersten H-Brücke mit dem ersten Leitungsabschnitt L1 verschaltet. Aus Gründen der Übersichtlichkeit sind bei allen Brückenschaltern die zugehörigen Steuerungseingänge nicht dargestellt. Der erste Leitungsabschnitt L1 umfasst hierbei neben der reinen stromdurchflossenen Leitung auch eine als Batterie dargestellte Spannungsquelle UQB. Hierbei kennzeichnen die jeweils in einem Kreis stehenden Nummern 30 und 31 ausgewählte Punkte der Kabelführung in einem Kraftfahrzeug, wobei die Nummern 30 im Allgemeinen den Pluseingang der Batterie bezeichnet und 31 die Rückleitung von dem Minuspol der Batterie zu der Karosserie des Massekabels in einem Kraftfahrzeug kennzeichnen. Mit dem Massekabel ist in einem Kraftfahrzeug der Minuspol der Batterie UQB mit der Karosserie verbunden. Der Leitungswiderstand des ersten Leitungsabschnitts L1 und der Innenwiderstand der Batterie UQB werden mittels eines einzigen Ersatzwiderstand RLA dargestellt. Die erste H-Brücke umfasst einen ersten Brückenschalter SH1, einen zweiten Brückenschalter SH2, einen dritten Brückenschalter SH3 und einen vierten Brückenschalter SH4. Bei ersten H-Brücke sind der erste Brückenschalter SH1 und der vierte Brückenschalter SH4 geöffnet und der zweite Brückenschalter SH2 und der dritte Brückenschalter SH3 geschlossen. Hierdurch wird die erste Stromquelle IQ1 derart mit der ersten Leitungsabschnitt L1 verschaltet, dass der erste Strom der I1 mit einer technischen Stromrichtungen in Richtung des Bezugspotentials bzw. des Massepotentials eingeprägt wird.

Zusätzlich zu der ersten Stromquelle IQ1 ist eine zweite Stromquelle IQ2 vorgesehen. Die zweite Stromquelle IQ2 ist mit einer zweiten H--Brücke mit einem zweiten nicht direkt dargestellten Leitungsabschnitt L2 verschaltet. Der Leitungswiderstand des zweiten Leitungsabschnitts L2 wird mittels eines Ersatzwiderstand RLB dargestellt. Die zweite H-Brücke umfasst einen fünften Brückenschalter SH5, einen sechsten Brückenschalter SH6, einen siebten Brückenschalter SH7 und einen achten Brückenschalter SH8. Bei zweiten H-Brücke sind der fünfte Brückenschalter SH5 und der achte Brückenschalter SH8 geschlossen und der sechste Brückenschalter SH6 und der siebente Brückenschalter SH7 geöffnet. Hierdurch wird die zweite Stromquelle IQ2 derart mit dem zweiten Leitungsabschnitt L2 verschaltet, dass ein zweiter Strom I2 mit einer technischen Stromrichtung entgegen der Richtung des ersten Stroms I1 eingeprägt wird.

Untersuchungen haben gezeigt, dass es besonders vorteilhaft ist, die Höhe des ersten Strom I1 entgegengesetzt gleich groß zu der Höhe des zweiten Stroms I2 auszubilden. Hierdurch wird das Leitungsnetz außerhalb der Überwachungseinrichtung, beispielsweise in Richtung eines nicht dargestellten Verbrauchers, nicht von der Überwachungseinrichtung belastet, d. h. ein zusätzlicher Spannungsabfall ist in dem Leitungsnetz außerhalb der Überwachungseinrichtung nicht vorhanden. Des Weiteren lässt sich mit der Überwachungseinrichtung besonders einfach und vorteilhaft auch eine Spannungsquelle, wie beispielsweise eine Batterie UQB, überwachen.

In der Figur 4b ist eine weitere bevorzugte Verschaltungsausführung der ersten Stromquelle IQ1 und der zweiten Stromquelle IQ2 dargestellt. Im Folgenden werden nur die Unterschiede zu der Ausführungsform dargestellt in der Figur 4b erläutert. Bei der ersten H-Brücke sind der erste Brückenschalter SH1 und der vierte Brückenschalter SH4 geschlossen und der zweite Brückenschalter SH2 und der dritte Brückenschalter SH3 geöffnet. Hierdurch wird die erste Stromquelle IQ1 derart mit der ersten Leitungsabschnitt L1 verschaltet, dass der erste Strom I1 mit einer technischen Stromrichtungen entgegen der Richtung hin zu dem Bezugspotential bzw. zu dem Massepotential eingeprägt wird.

Bei der zweiten H-Brücke sind der fünfte Brückenschalter SH5 und der achte Brückenschalter SH8 geöffnet und der sechste Brückenschalter SH6 und der siebente Brückenschalter SH7 geschlossen. Hierdurch wird die zweite Stromquelle IQ2 derart mit der zweiten Leitungsabschnitt L2 verschaltet, dass ein zweiter Strom I2 mit einer technischen Stromrichtung entgegen der Richtung des ersten Stroms I1 eingeprägt wird, d.h. der zweite Strom I2 wird also in Richtung zu dem Bezugspotential bzw. dem Massepotential eingeprägt. Es ist bevorzugt, die Höhe des ersten Stroms I1 gleich groß wie die Höhe des zweiten Stroms I2 auszubilden. Hierdurch wird auch mit der vorliegenden Ausführungsform das Leitungsnetz außerhalb der Überwachungseinrichtung nicht belastet, d. h. ein zusätzlicher Spannungsabfall ist in dem Leitungsnetz außerhalb der Überwachungseinrichtung nicht vorhanden.

Es sei angemerkt, dass sich auch weitere nicht dargestellte Verschaltungen der ersten Stromquelle IQ1 und der zweiten Stromquelle IQ2 mit den jeweiligen Leitungsabschnitten ausbilden lassen. Beispielweise lassen sich mit zwei weiteren Verschaltungsausführungen die Höhe des ersten Stroms I1 und die Höhe des zweiten Stroms I2 addieren. Des Weiteren ist es vorteilhaft, die erste Stromquelle IQ1 und die zweite Stromquelle IQ2 jeweils als steuerbare Stromquellen auszuführen und hierdurch die Größe des ersten Strom I1 und die Größe des zweiten Strom I2 einzustellen bzw. mittels der Steuerungseinheit ST zu regeln.

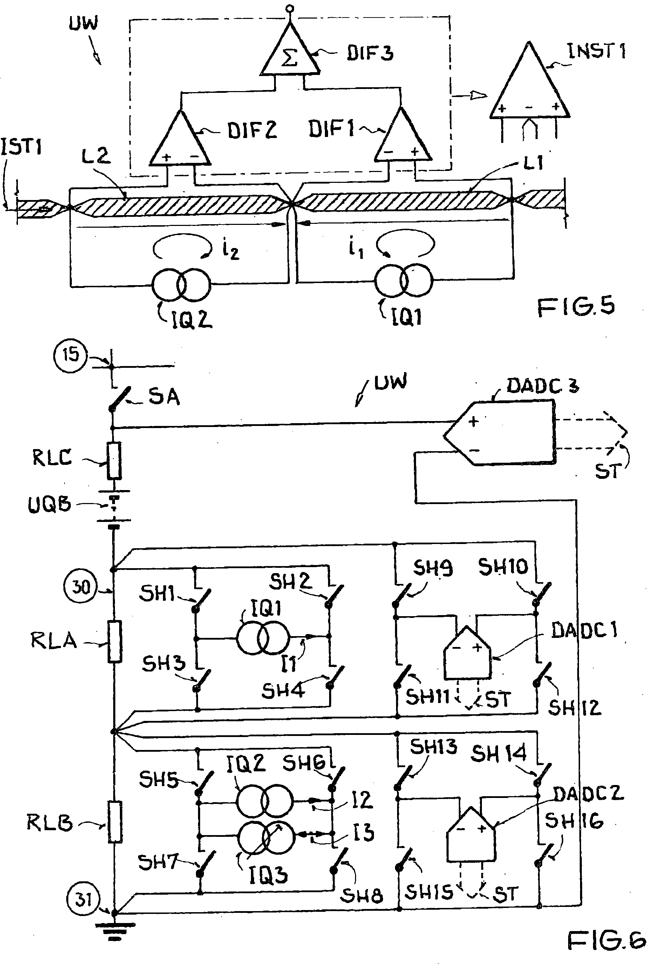

In der Abbildung der Figur 5 ist eine weitere Ausführungsform dargestellt. Die dargestellte Ausführungsform weist eine mehrstufige Verstärkereinheit INST1 auf und stellt aus Gründen der Übersichtlichkeit nur ein Teil der Überwachungseinheit in einem stark vereinfachten Ersatzschaltbild dar. Im Folgenden werden nur die Unterschiede zu den vorstehenden Abbildungen erläutert. Die mehrstufigen Verstärkereinheit INST1 umfasst den ersten Differenzverstärker DIF1, einen zweiten Differenzverstärker DIF2 und einen dritten Differenzverstärker DIF3. In dem ersten Leitungsabschnitt L1 wird zusätzlich zu dem fließenden Iststrom IST1 auch der erste Strom I1 eingeprägt. In dem zweiten Leitungsabschnitt L2 wird zusätzlich zu dem fließenden Iststrom IST1 auch der zweite Strom I2 eingeprägt. In der vorliegenden Ausführungsform ist der erste Strom I1 entgegengesetzt gleich groß zu dem zweiten Strom I2 gewählt.

Von dem zweiten Leitungsabschnitt L2 liegt die Spannung welche an dem Leitungswiderstand abfällt an einem ersten Eingang und an einem zweiten Eingang des zweiten Differenzverstärkers DIF2 an. An einem Ausgang des zweiten Differenzverstärkers DIF2 wird die verstärke Spannung ausgegeben. Der Ausgang des ersten Differenzverstärkers DIF1 ist mit einem ersten Eingang und der Ausgang des zweiten Differenzverstärkers DIF2 ist mit einem zweiten Eingang des dritten Differenzverstärkers DIF3 verschaltet. An einem Ausgang des dritten Differenzverstärkers DIF3 liegt die verstärke Spannung der Summe der beiden Ausgangsspannungen des ersten Differenzverstärkers DIF1 und des zweiten Differenzverstärkers DIF2 an. Im Unterschied zu den entgegengesetzten Stromrichtungen des ersten Stroms I1 und des zweiten Stroms I1 sind die Eingänge des ersten Differenzverstärkers DIF1 und die Eingänge des zweiten Differenzverstärkers DIF2 derart mit den jeweiligen Leitungsabschnitten verschaltet, dass sich der Spannungsabfall von dem ersten Leitungsabschnitt L1 und der Spannungsabfall an dem zweiten Leitungsabschnitt L2 addieren. Es sei angemerkt, dass zur Vereinfachung sowohl die erste Stromquelle IQ1 mit dem ersten Leistungsabschnitt L1 als auch die zweite Stromquelle IQ2 mit dem zweiten Leitungsabschnitt L2 als fest verdrahtet dargestellt sind.

Ein Vorteil ist, dass sich mit der Verschaltung von den drei Differenzverstärkern DIF1 - DIF3 als mehrstufige Verstärkereinheit INST1 auch sehr kleine Spannungen im Bereich unter 10 mV zuverlässig messen und auswerten lassen. Hierdurch lässt sich die Ermittlung des Iststroms IST1 auf einfache und zuverlässige und analoge Weise durchführen. Aus den analogen Ausgangsignalen der mehrstufigen Verstärkereinheit INST1 mit eingeprägten ersten Strom I1 und zweiten Strom I2 sowie ohne eingeprägten ersten Strom I1 und zweiten Strom I2 lässt sich mittels des Vergleichs der Spannungswerte der Gesamtwiderstand der ersten Leitungsabschnitts L1 und des zweiten Leitungsabschnitts L2 und hierdurch die Stromstärke des ersten Iststroms IST1 ermitteln. Insbesondere lässt sich durch eine Summenbildung an dem dritten Differenzverstärker DIF3 der Spannungsabfall durch den eingeprägten ersten Strom I1 ermitteln und hierdurch den Leitungswiderstand bestimmen. In einem weiteren Schritt lässt sich mittels einer Differenzbildung an dem dritten Differenzverstärker DIF3 den Spannungsabfall des ersten Iststroms IST1 und hierdurch die Stromstärke des ersten Iststroms bestimmen.

In der Abbildung der Figur 6 ist eine weitere besonders vorteilhafte Ausführungsform der Überwachungseinrichtung UW dargestellt. Aus Gründen der Übersichtlichkeit sind hierbei in dem vorliegenden Ersatzschaltbild nur Teile der Überwachungseinrichtung UW dargestellt. Im Folgenden werden nur die Unterschiede zu einen der vorstehenden Abbildungen erläutert. Die in einem Kreis stehende Nummer 15 kennzeichnet vorliegend einen weiteren ausgewählten Punkt bei der Kabelführung in einem Kraftfahrzeug. Neben dem ersten Leitungsabschnitt L1 und dem zweiten Leitungsabschnitt L2 mit den zugehörigen Ersatzwiderständen RLA bzw. RLB ist ein dritter Leitungsabschnitt L3 vorgesehen. Der dritte Leitungsabschnitt L3 umfasst vorliegend die Batterie UQB, den Innenwiderstand der Batterie UQB, einen Leitungsschalter SA mit einen nicht näher dargestellten Leitungsabschnitt zwischen dem Punkt mit der Nummer 15 und dem Pluspol der Batterie UQB. Alle Elemente des dritten Leitungsabschnittes werden mittels eines einzigen Ersatzwiderstands RLC dargestellt. Der Schalter SA verbindet oder trennt den Pluspol der Batterie UQB mit demjenigen Abschnitt der Leitung welcher mittels der Nummer 15 gekennzeichnet ist. Parallel zu der zweiten Stromquelle IQ2 ist eine dritte einstellbare Stromquelle IQ3 vorgesehen. Der Steuerungseingang der dritten Stromquelle IQ3 ist mit der Steuerungseinheit ST verschaltet - nicht dargestellt. Mittels der dritten Stromquelle IQ3 lässt sich auf einfache Weise die Höhe des **dritten** Strom **I3** Stroms derart erhöhen oder erniedrigen, so dass der Summenwert der beiden Ströme I2 und I3 exakt gleich dem Wert des ersten Stroms I1 entspricht.

Ferner ist eine erste Schaltungsvorrichtung DADC1 vorgesehen. Die erste Schaltungsvorrichtung DADC1 umfasst einen Analog Digital Wandler und einen Differenzverstärker und weist einen mittels einer dritten H-Brücke mit einem ersten Leitungsabschnitt L1 verschaltenden Differenzeingang und einen mit der Steuerungseinheit ST verschaltenden Ausgang auf. Aus Gründen der Übersichtlichkeit sind bei allen Brückenschaltern die zugehörigen Steuerungseingänge nicht dargestellt. Der erste Leitungsabschnitt L1 ist durch den Ersatzwiderstand RLA dargestellt. Die dritte H-Brücke umfasst einen neunten Brückenschalter SH9, einen zehnten Brückenschalter SH10, wobei alle Brückenschalter der dritten H-Brücke geöffnet dargestellt sind.

Zusätzlich zu der ersten Schaltungsvorrichtung DADC1 ist eine zweite Schaltungsvorrichtung DADC2 vorgesehen. Die zweite Schaltungsvorrichtung DADC2 umfasst einen Analog Digital Wandler und einen Differenzverstärker und weist einen mittels einer vierten H-Brücke mit einem zweiten Leitungsabschnitt L2 verschaltenden Differenzeingang und einen mit der Steuerungseinheit ST verschaltenden Ausgang auf. Der Leitungswiderstand des zweiten Leitungsabschnitts L2 wird mittels eines Ersatzwiderstand RLB dargestellt. Die vierte H-Brücke umfasst einen dreizehnten Brückenschalter SH13, einen vierzehnten Brückenschalter SH14, einen fünfzehnten Brückenschalter SH15 und einen sechzehnten Brückenschalter SH16. Bei der vierten H-Brücke sind alle Brückenschalter geöffnet.

Ferner sind alle Brückenschalter der ersten H-Brücke und alle Brückenschalter der zweiten H-Brücke geöffnet. Aus Gründen der Übersichtlichkeit sind die Steuerungseingänge der Brückenschalter der ersten H-Brücke bis einschließlich der Steuerungseingänge der Brückenschalter der vierten H-Brücke nicht dargestellt. Alle Steuerungseingänge sind vorzugsweise mit der Steuerungseinheit ST verschaltet - nicht dargestellt.

Indem sowohl die Stromquellen IQ1 bis IQ3 als auch die Schaltungsvorrichtungen DADC1 bis DADC3 jeweils mittels einer H-Brücke mit den zugeordneten Leitungsabschnitten verschaltet sind, ergibt sich eine große Flexibilität hinsichtlich der Messung der Spannungswerte an dem ersten Leitungsabschnitt L1 und an dem zweiten Leitungsabschnitt L2 und in der Kombination der einzelnen gemessenen Spannungswerte.

Des Weiteren sind ein erster Eingang einer dritten Schaltungsvorrichtung DADC3 mit dem Massepotential und ein zweiter Eingang der dritten Schaltungsvorrichtung DADC3 mit dem Pluspol der Batterie QUB verbunden. Der erste Eingang und der zweite Eingang bilden einen Differenzeingang aus. Der Ausgang der dritten Schaltungsvorrichtung DADC3 ist mit der Steuerungseinheit ST verschaltet. Die dritte Schaltungsvorrichtung DADC3 umfasst einen nicht näher dargestellten Differenzverstärker und einen Analog Digital Wandler.

Wird der Schalter SA geschlossen fließt der Iststrom IST1 aus der UQB und erzeugt eine Spannungsänderung an dem Differenzeingang der dritten Schaltungsvorrichtung. Die Spannungsänderung ergibt sich grundsätzlich aus einem Vergleich der an den Differenzeingang der dritten Schaltungsvorrichtung DADC3 anliegenden Spannung bei einem geöffneten Leitungsschalter SA und bei einem geschlossenen Leitungsschalter SA. Hierdurch lässt sich die Belastung der Batterien, d. h. die Größe der Stromentnahme ermitteln. Außerdem lässt sich bei einem geöffneten Leitungsschalter SA aus der gemessenen Spannung der Batterie UQB deren Ladezustand überwachen.

Untersuchungen haben gezeigt, dass sich bei einem geschlossenen Leitungsschalter SA bei einer Auswertung der Spannungswerte von der ersten Schaltungsvorrichtung DADC1 und der Spannungswerte bis einschließlich der drit-ten Schaltungsvorrichtung DADC3 sich insbesondere auf einen Nebenschluss der Batterie UQB schließen lässt.

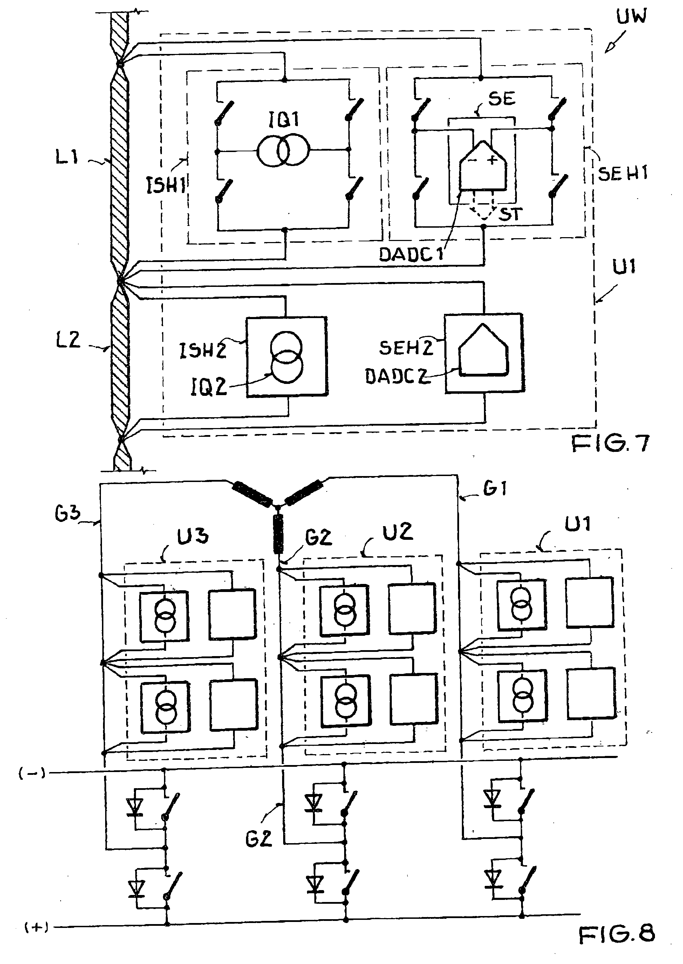

In der Abbildung der Figur 7 ist ein stark vereinfachtes Ersatzschaltbild eines Teil der Überwachungseinrichtung UW der Ausführungsform abgebildet in der Figur 6 dargestellt. Im Folgenden werden nur die Unterschiede zu einen der vorstehenden Abbildungen erläutert. Die erste H-Brücke mit der verbundenen ersten Stromquelle IQ1 ist als ein erster Schaltungsblock ISH1 zusammengefasst. Des Weiteren ist die zweite H-Brücke mit der verbundenen zweiten Stromquelle IQ2 als zweiter Schaltungsblock ISH2 zusammengefasst. Die dritte H-Brücke ist mit der verbundenen ersten Schaltungsvorrichtung DADC1 als erster Schaltungsabschnitt SEH1 und die vierte H-Brücke ist mit der verbundenen zweiten Schaltungsvorrichtung DADC2 als zweiter Schaltungsabschnitt SEH2 zusammengefasst. Der erste Schaltungsblock ISH1, der zweite Schaltungsblock ISH2, der erste Schaltungsabschnitt SEH1 und der zweite Schaltungsabschnitt SEH2 sind zu einer ersten Schaltungseinheit U1 zusammengefasst.

Die Abbildung der Figur 8 zeigt ein weiteres vereinfachtes Ersatzschaltbild einer Überwachungseinrichtung UW. Im Folgenden werden nur die Unterschiede zu einen der vorstehenden Abbildungen erläutert. Die Überwachungseinrichtung UW weist zusätzlich zu der ersten Schaltungseinheit U1 eine zweite Schaltungseinheit U2 und einer dritte Schaltungseinheit U3 auf. Die erste Schaltungseinheit U1 ist mit einem ersten Generatorzweig G1 und die zweite Schaltungseinheit U2 mit einem zweiten Generatorzweig G2 und die dritte Schaltungseinheit U3 mit einem dritten Generatorzweig G3 verschaltet. Hierdurch lässt sich die Stromstärken in jedem der drei Generatorzweige G1 bis G3 ermitteln und überwachen.

## Patentansprüche

1. Überwachungseinrichtung (UW) mit einem ersten Leitungsabschnitt (L1) mit einer ersten Anschlussstelle und einer von der ersten Anschlussstelle (AS1) in Leitungsrichtung beabstandeten zweiten Anschlussstelle (AS2), und mit einer Steuerungseinheit (ST) und mit einer ersten Stromermittlungseinheit (STE1), aufweisend
-- eine erste Stromquelle (IQ1), wobei die erste Stromquelle (IQ1) mit einer ersten Anschlussleitung (ANL1) mit der ersten Anschlussstelle (AS1) verschaltet ist und mit einer zweiten Anschlussleitung (ANL2) mit der zweiten Anschlussstelle (AS2) verschaltet ist und einen ersten Strom (I1) ausgibt,
-- einen ersten Schalter (S1) mit einem Steuerungseingang (EST1), wobei der erste Schalter(S1) in die zweite Anschlussleitung eingeschleift ist und die erste Stromquelle (IQ1) mit der zweiten Anschlussstelle (AS2) verbindet oder trennt,
-- einen ersten Differenzverstärker (DIF1) mit einen ersten Eingang, einem zweiten Eingang und einem Ausgang, wobei der erste Eingang mit einer dritten Anschlussleitung mit der ersten Anschlussstelle (AS1) verschaltet ist und der zweiter Eingang mit einer vierten Anschlussleitung mit der zweiten Anschlussstelle (AS2) verschaltet ist,
wobei die Steuerungseinheit (ST) zwischen dem Ausgang des ersten Differenzverstärkers (DIF1) und dem Steuerungseingang des ersten Schalters (S1) eingeschleift ist, und
der erste Leitungsabschnitt (L1) mit einem Iststrom (IST1) beaufschlagt ist und in einem ersten Zustand der erste Schalter geschlossen ist und der ersten Strom (I1) in dem ersten Leitungsabschnitt (L1) zusätzlich zu dem ersten Iststrom (IST1) eingeprägt ist und zwischen dem ersten Eingang und dem zweiten Eingang des ersten Differenzverstärkers (DIF1) eine Spannung bedingt durch die Größe des Iststroms (IST1) und die Größe des ersten Stroms (I1) anliegt, und
in einem zweiten Zustand der erste Schalter (S1) geöffnet ist und zwischen dem ersten Eingang und dem zweiten Eingang des ersten Differenzverstärkers (DIF1) eine zweite ausschließlich durch den Iststrom (IST1) bedingte Spannung anliegt,
**dadurch gekennzeichnet, dass**
ein zweiter Leitungsabschnitt (L2) mit einer zweiten Stromermittlungseinheit mit einem zweiten Differenzverstärker (DIF2) vorgesehen ist und ein zweiter Strom (I2) mittels einer zweiten Stromquelle IQ2 in den zweiten Leitungsabschnitt (L2) eingespeist ist, und
der erste Strom (I1) und der zweite Strom (I2) im Wesentlichen entgegengesetzt gleich groß sind, und
die Steuerungseinheit (ST) einen dritten Differenzverstärker (DIF3) aufweist und ein erster Eingang des dritten Differenzverstärkers (DIF3) mit dem Ausgang des ersten Differenzverstärkers (DIF1) und ein zweiter Eingang des dritten Differenzverstärkers (DIF3) mit dem Ausgang des zweiten Differenzverstärkers (DIF2) verschaltet ist und der erste Differenzverstärker (DIF1) mit dem zweiten Differenzverstärker (DIF2) und dem dritten Differenzverstärker (DIF3) eine mehrstufigen Verstärkereinheit (INST1) ausbilden, und am Ausgang der mehrstufigen Verstärkereinheit eine Summe der an dem ersten Leitungsabschnitt und dem zweiten Leitungsabschnitt gemessenen Spannungsdifferenzen anliegt, und
und die Steuerungseinheit (ST) eingerichtet ist, aus den Spannungen des ersten Zustands und des zweiten Zustands die Größe des Iststroms (IST1) zu bestimmen.

2. Überwachungseinrichtung (UW) nach Anspruch 1, **dadurch gekennzeichnet, dass** der erste Strom (I1) ein Gleichstrom oder ein Wechselstrom ist.

3. Überwachungseinrichtung (UW) nach Anspruch 1 oder Anspruch 2, **dadurch gekennzeichnet, dass** die erste Stromquelle einen mit der Steuerungseinheit verschalteten Steuerungseingang aufweist.

4. Überwachungseinrichtung (UW) nach einem der vorstehenden Ansprüche, **dadurch gekennzeichnet, dass** die erste Stromermittlungseinheit einen ADC umfasst und der ADC zwischen der Steuerungseinheit und dem Ausgang des ersten Differenzverstärkers geschaltet ist.

5. Überwachungseinrichtung (UW) nach einem der vorstehenden Ansprüche, **dadurch gekennzeichnet, dass** die erste Stromquelle (IQ1) mittels des ersten Brückenschalters (SH1) und eines zweiten Brückenschalters (SH2) und eines dritten Brückenschalters (SH3) und eines vierten Brückenschalters (SH4) in Form einer H-Brückenschaltung mit dem ersten Leitungsabschnitt (L1) verschaltet ist.

6. Überwachungseinrichtung (UW) nach einem der vorstehenden Ansprüche, **dadurch gekennzeichnet, dass** der erste Differenzverstärker (DIF1) mittels einer H-Brückenschaltung mit dem ersten Leitungsabschnitt (L1) verschaltet ist.

7. Überwachungseinrichtung (UW) nach einem Ansprüche 4 bis 7, **dadurch gekennzeichnet, dass** eine erste Schaltungsvorrichtung (DADC1) bestehend aus dem ersten Differenzverstärker (DIF1) und dem ersten Analog Digital Wandler (ADC1) mittels einer H-Brückenschaltung mit dem ersten Leitungsabschnitt (L1) verschaltet ist.

8. Überwachungseinrichtung (UW) nach einem der vorstehenden Ansprüche, **dadurch gekennzeichnet, dass** eine zweite H-Brücke vorgesehen ist, wobei die zweite Stromquelle (IQ2) mittels des fünften Brückenschalters (SH5) und eines sechsten Brückenschalters (SH6) und eines siebten Brückenschalters (SH7) und eines achten Brückenschalters (SH8) in Form einer H-Brückenschaltung mit dem zweiten Leitungsabschnitt (L2) verschaltet ist.

9. Überwachungseinrichtung (UW) nach Anspruch 8, **dadurch gekennzeichnet, dass** der zweite Leitungsabschnitt (L2) unmittelbar an den ersten Leitungsabschnitt (L1) grenzt.

10. Überwachungseinrichtung (UW) nach einem der vorangegangenen Ansprüche, **dadurch gekennzeichnet, dass** die Steuerungseinheit (ST) eingerichtet ist, die Größe des Iststroms (IST1) mittels des Wertes der Spannung in dem ersten Zustand und mittels des Wertes der Spannung in den zweiten Zustand und der Größe des ersten Stroms (I1) zu bestimmen.

11. Überwachungseinrichtung (UW) nach einem der vorangegangenen Ansprüche, **dadurch gekennzeichnet, dass** die Steuerungseinheit (ST) eingerichtet ist, die Größe des Iststroms (IST1) ohne Berechnung oder Kenntnis des Widerstandes des ersten Leitungsabschnitts (L1) zu bestimmen.

12. Verfahren zur Überwachung eines ersten Leitungsabschnitts (L1) mit einer Überwachungseinrichtung (UW), wobei der erste Leitungsabschnitt (L1) eine erste Anschlussstelle (AS1) und einer von der ersten Anschlussstelle (AS1) in Leitungsrichtung beabstandete zweite Anschlussstelle (AS2) aufweist, die Überwachungseinrichtung (UW) eine Steuerungseinheit (ST) und eine erste Stromermittlungseinheit (STE1) aufweist, und die erste Stromermittlungseinheit (STE1) aufweist:
-- eine erste Stromquelle (IQ1), wobei die erste Stromquelle (IQ1) mit einer ersten Anschlussleitung mit der ersten Anschlussstelle (AS1) und mit einer zweiten Anschlussleitung mit der zweiten Anschlussstelle (AS2) verschaltet ist und einen ersten Strom (I1) ausgibt,
-- einen ersten Schalter (S1) mit einem Steuerungseingang und der erste Schalter (S1) in die erste Anschlussleitung eingeschleift ist und die erste Stromquelle (IQ1) mit der ersten Anschlussstelle (AS2) verbindet oder trennt
-- einen ersten Differenzverstärker (DIF1), mit einen ersten Eingang, einem zweiten Eingang und einem Ausgang, wobei der erste Eingang mit einer dritten Anschlussleitung mit der ersten Anschlussstelle (AS1) verschaltet ist und der zweiter Eingang mit einer vierten Anschlussleitung mit der zweiten Anschlussstelle (AS2) verschaltet ist,
wobei die Steuerungseinheit (ST) zwischen dem Ausgang des ersten Differenzverstärkers (DIF1) und dem Steuerungseingang des Schalters (S1) eingeschleift ist, und
der erste Leitungsabschnitt mit einem Iststrom (IST1) beaufschlagt wird und in einem ersten Zustand der erste Schalter (S1) geschlossen ist und der erste Strom (I1) in dem ersten Leitungsabschnitt (L1) zusätzlich zu dem Iststrom (IST1) eingeprägt wird und zwischen dem ersten Eingang und dem zweiten Eingang des ersten Differenzverstärkers (DIF1) eine Spannung bedingt durch die Größe des Iststroms (IST1) und die Größe des ersten Stroms (I1) anliegt,
in einem zweiten Zustand der erste Schalter (S1) geöffnet wird und zwischen dem ersten Eingang und dem zweiten Eingang des ersten Differenzverstärkers (DIF1) eine zweite ausschließlich durch den Iststrom (IST1) bedingte Spannung anliegt, und
in einem zweiten Zustand der erste Schalter (S1) geöffnet ist und zwischen dem ersten Eingang und dem zweiten Eingang des ersten Differenzverstärkers (DIF1) eine zweite ausschließlich durch den Iststrom (IST1) bedingte Spannung anliegt,
**dadurch gekennzeichnet, dass**
ein zweiter Leitungsabschnitt (L2) mit einer zweiten Stromermittlungseinheit mit einem zweiten Differenzverstärker (DIF2) vorgesehen ist und ein zweiter Strom (I2) mittels einer zweiten Stromquelle IQ2 in den zweiten Leitungsabschnitt (L2) eingespeist wird, und
der erste Strom (I1) und der zweite Strom (12) im Wesentlichen entgegengesetzt gleich groß sind, und
die Steuerungseinheit (ST) einen dritten Differenzverstärker (DIF3) aufweist und ein erster Eingang des dritten Differenzverstärkers (DIF3) mit dem Ausgang des ersten Differenzverstärkers (DIF1) und ein zweiter Eingang des dritten Differenzverstärkers (DIF3) mit dem Ausgang des zweiten Differenzverstärkers (DIF2) verschaltet wird und der erste Differenzverstärker (DIF1) mit dem zweiten Differenzverstärker (DIF2) und dem dritten Differenzverstärker (DIF3) eine mehrstufigen Verstärkereinheit (INST1) ausbilden, und am Ausgang der mehrstufigen Verstärkereinheit eine Summe der an dem ersten Leitungsabschnitt und dem zweiten Leitungsabschnitt gemessenen Spannungsdifferenzen anliegt, und
mittels der Steuerungseinheit (ST) aus den beiden Spannungen aus dem ersten Zustand und dem zweiten Zustand die Größe des Iststroms (IST1) bestimmt wird.

13. Verfahren nach Anspruch 12, **dadurch gekennzeichnet, dass** mittels der Steuereinheit (ST) ein Wechselstrom in den ersten Leitungsabschnitt eingespeist wird und mittels eines Lock-In Prinzips die Größe des Iststroms (IST1) bestimmt wird.

14. Verfahren nach Anspruch 12 oder Anspruch 13, **dadurch gekennzeichnet, dass** mittels der Steuerungseinheit (ST) die Größe des Iststroms (IST1) mittels des Wertes der Spannung in dem ersten Zustand und mittels des Wertes der Spannung in den zweiten Zustand und der Größe des ersten Stroms (I1) bestimmt wird.

15. Verwendung der Überwachungseinrichtung (UW) nach einem der vorstehenden Ansprüche für eine Kontrolle von Strangströmen eines Generators oder eines Elektromotors.

16. Verwendung der Überwachungseinrichtung (UW) nach einem der vorstehenden Ansprüche zur Bestimmung des Ladezustands einer Batterie oder zur Kontrolle der Stromstärke in einem Pluszweig zwischen der Batterie und einem Verbraucher oder zur Kontrolle der Stromstärke in einem Pluszweig zwischen der Batterie innerhalb des Bordnetzes eines Autos und einem Verbraucher.

17. Verwendung der Überwachungseinrichtung (UW) nach einem der vorstehenden Ansprüche zur Kontrolle des Stromes in Massezuleitungen in einem Kraftfahrzeug.

18. Verwendung der Überwachungseinrichtung (UW) nach einem der vorstehenden Ansprüche zur In-situ-Kalibration von unbekannten Stromstärken in einem Leitungssegment, wobei die Variation der Stromstärke in dem Leitungssegment wenigstens eine Zehnerpotenz umfasst.

## Claims

1. Monitoring device (UW) with a first conductor section (L1) with a first connecting point and a second connecting point (AS2) spaced from the first connecting point (AS1) in direction of conducting and with a control unit (ST) and a first current detecting unit (STE1), comprising
- a first current source (IQ1), wherein the first current source (IQ1) is connected by a first connecting line (ANL1) with the first connecting point (AS1) and by a second connecting line (ANL2) with the second connecting point (AS2) and outputs a first current (I1),
- a first switch (S1) with a control input (EST1), wherein the first switch (S1) is connected into the second connecting line and connects the first current source (IQ1) with or separates the first current source (IQ1) from the second connecting point (AS2) and
- a first differential amplifier (DIF1) with a first input, a second input and an output, wherein the first input is connected by a third connecting line with the first connecting point (AS1) and the second input is connected by a fourth connecting line with the second connecting point (AS2),
wherein the control unit (ST) is connected between the output of the first differential amplifier (DIF1) and the control input of the first switch (S1),
the first conductor section (L1) is acted on by an actual current (IST1) and in a first state the first switch is closed and the first current (I1) is imposed in the first conductor section (L1) additionally to the first actual current (IST1) and a voltage attributable to the magnitude of the actual current (IST1) and the magnitude of the first current (I1) is present between the first input and the second input of the first differential amplifier (DIF1) and
in a second state the first switch (S1) is open and a second voltage attributable exclusively to the actual current (IST1) is present between the first input and the second input of the first differential amplifier (D1F1),
**characterised in that**
a second conductor section (L2) with a second current detecting unit with a second differential amplifier (DIF2) is provided and a second current (I2) is supplied by means of a second current source (IQ2) to the second conductor section (L2),
the first current (I1) and the second current (I2) are substantially equal but opposite,
the control unit (ST) comprises a third differential amplifier (DIF3) and a first input of the third differential amplifier (DIF3) is connected with the output of the first differential amplifier (DIF1) and a second input of the third differential amplifier (DIF3) is connected with the output of the second differential amplifier (DIF2), the first differential amplifier (DIF1) together with the second differential amplifier (DIF2) and the third differential amplifier (DIF3) forming a multi-stage amplifier unit (INST1) and a sum of the voltage differences measured at the first conductor section and the second conductor section being present at the output of the multi-stage amplifier unit, and
the control unit (ST) is arranged to determine the magnitude of the actual current (IST1) from the voltages of the first state and the second state.

2. Monitoring device (UW) according to claim 1, **characterised in that** the first current (I1) is a direct current or an alternating current.

3. Monitoring device (UW) according to claim 1 or claim 2, **characterised in that** the first current source has a control input connected with the control unit.

4. Monitoring device (UW) according to any one of the preceding claims, **characterised in that** the first current detecting unit comprises an analog-to-digital converter and the analog-to-digital converter is connected between the control unit and the output of the first differential amplifier.

5. Monitoring device (UW) according to any one of the preceding claims, **characterised in that** the first current source (IQ1) is connected with the first conductor section (L1) by means of the first bridge switch (SH1), a second bridge switch (SH2), a third bridge switch (SH3) and a fourth bridge switch (SH4) in the form of an H-bridge circuit.

6. Monitoring device (UW) according to any one of the preceding claims, **characterised in that** the first differential amplifier (DIF1) is connected with the first conductor section (L1) by means of an H-bridge circuit.

7. Monitoring device (UW) according to any one of t claims 4 to 7, **characterised in that** a first switching device (DADC1) consisting of the first differential amplifier (DIF1) and the first analog-to-digital converter (ADC1) is connected with the first conductor section (L1) by means of an H-bridge circuit.

8. Monitoring device (UW) according to any one of the preceding claims, **characterised in that** a second H-bridge is provided, wherein the second current source (IQ2) is connected with the second conductor section (L2) by means of the fifth bridge switch (SH5), a sixth bridge switch (SH6), a seventh bridge switch (SH7) and an eighth bridge switch (SH8) in the form of an H-bridge circuit.

9. Monitoring device (UW) according to claim 8, **characterised in that** the second conductor section (L2) directly adjoins the first conductor section (L1).

10. Monitoring device (UW) according to any one of the preceding claims, **characterised in that** the control unit (ST) is arranged to determine the magnitude of the actual current (IST1) by means of the value of the voltage in the first state and by means of the value of the voltage in the second state and the magnitude of the first current (I1).

11. Monitoring device (UW) according to any one of the preceding claims, **characterised in that** the control unit (ST) is arranged to determine the magnitude of the actual current (IST1) without calculation or knowledge of the resistance of the first conductor section (L1).

12. Method for monitoring a first conductor section (L1) by a first monitoring device (UW), wherein the first conductor section (L1) has a first connecting point (AS1) and a second connecting point (AS2) spaced from the first connecting point (AS1) in the direction of conducting, which monitoring device (UW) comprises a control unit (ST) and a first current detecting unit (STE1), and the first current detecting unit (STE1) comprises:
- a first current source (IQ1), wherein the first current source (IQ1) is connected by a first connecting line (ANL1) with the first connecting point (AS1) and by a second connecting line (ANL2) with the second connecting point (AS2) and outputs a first current (11),
- a first switch (S1) with a control input (EST1), the first switch (S1) being connected into the second connecting line and connecting the first current source (IQ1) with or separating the first current source (IQ1) from the second connecting point (AS2) and
- a first differential amplifier (DIF1) with a first input, a second input and an output, wherein the first input is connected by a third connecting line with the first connecting point (AS1) and the second input is connected by a fourth connecting line with the second connecting point (AS2),
wherein the control unit (ST) is connected between the output of the first differential amplifier (DIF1) and the control input of the first switch (S1),
the first conductor section (L1) is acted on by an actual current (IST1) and in a first state the first switch is closed and the first current (I1) is imposed in the first conductor section (L1) additionally to the first actual current (IST1) and a voltage attributable to the magnitude of the actual current (IST1) and the magnitude of the first current (I1) is present between the first input and the second input of the first differential amplifier (DIF1) and
in a second state the first switch (S1) is open and a second voltage attributable exclusively to the actual current (IST1) is present between the first input and the second input of the first differential amplifier (DIF1),
**characterised in that**
a second conductor section (L2) with a second current detecting unit with a second differential amplifier (DIF2) is provided and a second current (I2) is supplied by means of a second current source (IQ2) to the second conductor section (L2),
the first current (I1) and the second current (I2) are substantially equal but opposite,
the control unit (ST) comprises a third differential amplifier (DIF3) and a first input of the third differential amplifier (DIF3) is connected with the output of the first differential amplifier (DIF1) and a second input of the third differential amplifier (DIF3) is connected with the output of the second differential amplifier (DIF2), the first differential amplifier (DIF1) together with the second differential amplifier (DIF2) and the third differential amplifier (DIF3) forming a multi-stage amplifier unit (INST1) and a sum of the voltage differences measured at the first conductor section and the second conductor section being present at the output of the multi-stage amplifier unit, and
the magnitude of the actual current (IST1) is determined by means of the control unit (ST) from the two voltages of the first state and the second state.

13. Method according to claim 12, **characterised in that** an alternating current is supplied to the first conductor section and the magnitude of the actual current (IST1) is determined by means of a lock-in principle.

14. Method according to claim 12 or claim 13, **characterised in that** the magnitude of the actual current (IST1) is determined by means of the control unit (ST) by way of the value of the voltage in the first state and by way of the value of the voltage in the second state and the magnitude of the first current (I1).

15. Use of the monitoring device (UW) according to one of the preceding claims for control of phase currents of a generator or an electric motor.

16. Use of the monitoring device (UW) according to any one of the preceding claims for determining the charge state of a battery or for controlling the current intensity in a positive branch between the battery and a consumer or for controlling the current density in a positive branch between the battery, which is within the on-board power supply of a car, and a consumer.

17. Use of the monitoring device (UW) according to any one of the preceding claims for controlling the current in ground conductors in a motor vehicle.

18. Use of the monitoring device (UW) according to any one of the preceding device claims for in-situ calibration of unknown current densities in a conductor segment, wherein the variation of the current density in the line conductor segment has at least a power of ten.

## Revendications

1. Dispositif de surveillance (UW) avec un premier segment conducteur (L1) avec un premier point de raccordement et un deuxième point de raccordement (AS2) espacé du premier point de raccordement (AS1) dans la direction du conducteur, et avec une unité de commande (ST) et avec une première unité de détection de courant (STE1), présentant
- une première source de courant (IQ1), la première source de courant (IQ1) étant connectée au premier point de raccordement (AS1) avec un premier conducteur de raccordement (ANL1) et connectée au deuxième point de raccordement (AS2) avec un deuxième conducteur de raccordement (ANL2) et produit un premier courant (I1),
- un premier interrupteur (S1) avec une entrée de commande (EST1), dans lequel le premier interrupteur (S1) est monté dans le deuxième conducteur de raccordement et il relie la première source de courant (IQ1) au deuxième point de raccordement (AS2) ou il l'en sépare,
- un premier amplificateur différentiel (DIF1) avec une première entrée, une deuxième entrée et une sortie, dans lequel la première entrée est connectée au premier point de raccordement (AS1) avec un troisième conducteur de raccordement et la deuxième entrée est connectée au deuxième point de raccordement (AS2) avec un quatrième conducteur de raccordement,
dans lequel l'unité de commande (ST) est montée entre la sortie du premier amplificateur différentiel (DIF1) et l'entrée de commande du premier interrupteur (S1), et
le premier segment conducteur (L1) est alimenté avec un courant réel (IST1) et, dans un premier état, le premier interrupteur est fermé et le premier courant (I1) est présent dans le premier segment conducteur (L1) en plus du premier courant réel (IST1) et il existe entre la première entrée et la deuxième entrée du premier amplificateur différentiel (DIF1) une tension définie par la grandeur du courant réel (IST1) et la grandeur du premier courant (I1) et,
dans un deuxième état, le premier interrupteur (S1) est ouvert et il existe entre la première entrée et la deuxième entrée du premier amplificateur différentiel (DIF1) une deuxième tension définie exclusivement par le courant réel (IST1),
**caractérisé en ce que**
il est prévu un deuxième segment conducteur (L2) avec une deuxième unité de détection de courant avec un deuxième amplificateur différentiel (DIF2) et un deuxième courant (I2) est injecté au moyen d'une deuxième source de courant (IQ2) dans le deuxième segment conducteur (L2), et
le premier courant (I1) et le deuxième courant (I2) sont essentiellement de même valeur opposée, et
l'unité de commande (ST) présente un troisième amplificateur différentiel (DIF3) et une première entrée du troisième amplificateur différentiel (DIF3) est connectée à la sortie du premier amplificateur différentiel (DIF1) et une deuxième entrée du troisième amplificateur différentiel (DIF3) est connectée à la sortie du deuxième amplificateur différentiel (DIF2) et le premier amplificateur différentiel (DIF1) forme avec le deuxième amplificateur différentiel (DIF2) et le troisième amplificateur différentiel (DIF3) une unité d'amplificateur à plusieurs étages (INST1) et une somme des différences de tension mesurées au premier segment conducteur et au deuxième segment conducteur est présente à la sortie de l'unité d'amplificateur à plusieurs étages et
l'unité de commande (ST) est conçue pour déterminer la grandeur du courant réel (IST1) à partir des tensions du premier état et du deuxième état.

2. Dispositif de surveillance (UW) selon la revendication 1, **caractérisé en ce que** le premier courant (I1) est un courant continu ou un courant alternatif.

3. Dispositif de surveillance (UW) selon la revendication 1 ou la revendication 2, **caractérisé en ce que** la première source de courant présente une entrée de commande connectée à l'unité de commande.

4. Dispositif de surveillance (UW) selon l'une quelconque des revendications précédentes, **caractérisé en ce que** la première unité de détection de courant comprend un convertisseur analogique-numérique (ADC) et l'ADC est connecté entre l'unité de commande et la sortie du premier amplificateur différentiel.

5. Dispositif de surveillance (UW) selon l'une quelconque des revendications précédentes, **caractérisé en ce que** la première source de courant (IQ1) est connectée au premier segment conducteur (L1) au moyen du premier interrupteur de pont (SH1) et d'un deuxième interrupteur de pont (SH2) et d'un troisième interrupteur de pont (SH3) et d'un quatrième interrupteur de pont (SH4) sous la forme d'un circuit de pont en H.

6. Dispositif de surveillance (UW) selon l'une quelconque des revendications précédentes, **caractérisé en ce que** le premier amplificateur différentiel (DIF1) est connecté au premier segment conducteur (L1) au moyen d'un circuit de pont en H.

7. Dispositif de surveillance (UW) selon l'une quelconque des revendications 4 à 7, **caractérisé en ce qu'**un premier dispositif de circuit (DADC1) composé du premier amplificateur différentiel (DIF1) et du premier convertisseur analogique-numérique (ADC1) est connecté au premier segment conducteur (L1) au moyen d'un circuit de pont en H.

8. Dispositif de surveillance (UW) selon l'une quelconque des revendications précédentes, **caractérisé en ce qu'**il est prévu un deuxième pont en H, dans lequel la deuxième source de courant (IQ2) est connectée au deuxième segment conducteur (L2) au moyen du cinquième interrupteur de pont (SH5) et d'un sixième interrupteur de pont (SH6) et d'un septième interrupteur de pont (SH7) et d'un huitième interrupteur de pont (SH8) sous la forme d'un circuit de pont en H.

9. Dispositif de surveillance (UW) selon la revendication 8, **caractérisé en ce que** le deuxième segment conducteur (L2) jouxte immédiatement le premier segment conducteur (L1).

10. Dispositif de surveillance (UW) selon l'une quelconque des revendications précédentes, **caractérisé en ce que** l'unité de commande (ST) est conçue pour déterminer la grandeur du courant réel (IST1) au moyen de la valeur de la tension dans le premier état et au moyen de la valeur de la tension dans le deuxième état et de la grandeur du premier courant (I1).

11. Dispositif de surveillance (UW) selon l'une quelconque des revendications précédentes, **caractérisé en ce que** l'unité de commande (ST) est conçue pour déterminer la grandeur du courant réel (IST1) sans calcul ou connaissance de la résistance du premier segment conducteur (L1).

12. Procédé de surveillance d'un premier segment conducteur (L1) avec un dispositif de surveillance (UW), dans lequel le premier segment conducteur (L1) présente un premier point de raccordement (AS1) et un deuxième point de raccordement (AS2) espacé du premier point de raccordement (AS1) dans la direction du conducteur, le dispositif de surveillance (UW) présente une unité de commande (ST) et une première unité de détection de courant (STE1) et la première unité de détection de courant (STE1) présente:
- une première source de courant (IQ1), dans lequel la première source de courant (IQ1) est connectée au premier point de raccordement (AS1) avec un premier conducteur de raccordement et au deuxième point de raccordement (AS2) avec un deuxième conducteur de raccordement et produit un premier courant (I1),
- un premier interrupteur (S1) avec une entrée de commande et le premier interrupteur (S1) est monté dans le premier conducteur de raccordement et il relie la première source de courant (IQ1) au premier point de raccordement (AS2) ou il l'en sépare,
- un premier amplificateur différentiel (DIF1), avec une première entrée, une deuxième entrée et une sortie, dans lequel la première entrée est connectée au premier point de raccordement (AS1) avec un troisième conducteur de raccordement et la deuxième entrée est connectée au deuxième point de raccordement (AS2) avec un quatrième conducteur de raccordement,
dans lequel l'unité de commande (ST) est montée entre la sortie du premier amplificateur différentiel (DIF 1) et l'entrée de commande de l'interrupteur (S1), et le premier segment conducteur est alimenté avec un courant réel (IST1) et dans un premier état le premier interrupteur (S1) est fermé et le premier courant (I1) est présent dans le premier segment conducteur (L1) en plus du premier courant réel (IST1) et il existe entre la première entrée et la deuxième entrée du premier amplificateur différentiel (DIF1) une tension définie par la grandeur du courant réel (IST1) et la grandeur du premier courant (I1),
dans un deuxième état, le premier interrupteur (S1) sera ouvert et il existe entre la première entrée et la deuxième entrée du premier amplificateur différentiel (DIF1) une deuxième tension définie exclusivement par le courant réel (IST1) et
dans un deuxième état, le premier interrupteur (S1) est ouvert et il existe entre la première entrée et la deuxième entrée du premier amplificateur différentiel (DIF1) une deuxième tension définie exclusivement par le courant réel (IST1), **caractérisé en ce que**
il est prévu un deuxième segment conducteur (L2) avec une deuxième unité de détection de courant avec un deuxième amplificateur différentiel (DIF2) et on injecte un deuxième courant (12) au moyen d'une deuxième source de courant (IQ2) dans le deuxième segment conducteur (L2), et
le premier courant (I1) et le deuxième courant (I2) sont essentiellement de même valeur opposée, et
l'unité de commande (ST) présente un troisième amplificateur différentiel (DIF3) et on connecte une première entrée du troisième amplificateur différentiel (DIF3) à la sortie du premier amplificateur différentiel (DIF1) et une deuxième entrée du troisième amplificateur différentiel (DIF3) à la sortie du deuxième amplificateur différentiel (DIF2) et le premier amplificateur différentiel (DIF1) forme avec le deuxième amplificateur différentiel (DIF2) et le troisième amplificateur différentiel (DIF3) une unité d'amplificateur à plusieurs étages (INST1) et une somme des différences de tension mesurées au premier segment conducteur et au deuxième segment conducteur est présente à la sortie de l'unité d'amplificateur à plusieurs étages et
on détermine au moyen de l'unité de commande (ST) la grandeur du courant réel (IST1) à partir des deux tensions du premier état et du deuxième état.

13. Procédé selon la revendication 12, **caractérisé en ce que** l'on injecte au moyen de l'unité de commande (ST) un courant alternatif dans le premier segment conducteur et on détermine la grandeur du courant réel (IST1) au moyen d'un principe de détection synchrone.

14. Procédé selon la revendication 12 ou la revendication 13, **caractérisé en ce que** l'on détermine au moyen de l'unité de commande (ST) la grandeur du courant réel (IST1) au moyen de la valeur de la tension dans le premier état et au moyen de la valeur de la tension dans le deuxième état et de la grandeur du premier courant (I1).

15. Utilisation du dispositif de surveillance (UW) selon l'une quelconque des revendications précédentes pour le contrôle de courants de phase d'un générateur ou d'un moteur électrique.

16. Utilisation du dispositif de surveillance (UW) selon l'une quelconque des revendications précédentes pour la détermination de l'état de charge d'une batterie ou pour le contrôle de l'intensité du courant dans une branche positive entre la batterie et un consommateur ou pour le contrôle de l'intensité du courant dans une branche positive entre la batterie à l'intérieur du réseau embarqué d'une auto et un consommateur.

17. Utilisation du dispositif de surveillance (UW) selon l'une quelconque des revendications précédentes pour le contrôle du courant dans des conducteurs de masse dans un véhicule automobile.

18. Utilisation du dispositif de surveillance (UW) selon l'une quelconque des revendications précédentes pour le calibrage *in situ* d'intensités de courant inconnues dans un segment conducteur, dans laquelle la variation de l'intensité de courant dans le segment conducteur comprend au moins une puissance dix.
